# EUROPÄISCHE PATENTANMELDUNG

(11) **EP 0 592 696 A1**
(43) Veröffentlichungstag der Anmeldung: **20.04.1994**
(21) Anmeldenummer: 92117216.9
(22) Anmeldetag: 08.10.1992
(51) Int. Cl.: H02M 7/538

(54) **Beschaltungsnetz für ein Zweigpaar**

(71) Anmelder: SIEMENS AKTIENGESELLSCHAFT, D-80333 München (DE)
(72) Erfinder: Seidl, Udo, Dipl.-Ing., W-8520 Erlangen (DE)

(57) **Zusammenfassung**

Die Erfindung bezieht sich auf ein Beschaltungsnetz für ein aus zwei abschaltbaren Leistungshalbleitern (T1,T2) bestehendes Zweigpaar (36), bestehend aus einer RCD-Zweigpaarbeschaltung (38), die zwei RCD-Beschaltungen (40,42)enthält. Erfindungsgemäß ist jeweils zu einem Widerstand (R1,R2) der RCD-Beschaltungen (40,42) elektrisch derart eine weitere Diode (D1',D2') parallel geschaltet, daß die Anode der einen weiteren Diode (D2') elektrisch leitend mit einem positiven Gleichspannungs-Anschluß (48) und die Kathode der anderen weiteren Diode (D1') elektrisch leitend mit einem negativen Gleichspannungs-Anschluß (46) des Zweigpaares (36) verknüpft sind. Somit erhält man eine RCD²-Zweigpaarbeschaltung für Zweigpaare (36), die in mehrpulsigen Stromrichter-Brückenschaltungen verwendet werden, wobei eine pulsende Spannungsüberhöhung auf einer Zwischenkreisverschienung (32) weitgehend vermieden wird.

## Beschreibung

Die Erfindung bezieht sich auf ein Beschaltungsnetz für ein aus zwei abschaltbaren Leistungshalbleitern bestehendes Zweigpaar, bestehend aus einer RCD-Zweigpaarbeschaltung, die zwei RCD-Beschaltungen enthält und deren Verwendung für eine mehrpulsige Stromrichter-Brückenschaltung verwendbar ist.

RCD-Beschaltungen für schnellschaltende Insulated-Gate-Bipolar-Transistoren (IGBT) sind aus der Zeitschrift "etz", Band 110, 1989, Heft 10, Seiten 464 bis 471, und für schnellschaltende bipolare Leistungstransistoren (LTR) aus der Zeitschrift "etz", Band 109, 1989, Heft 19, Seiten 894 bis 899, bekannt. Diese RCD-Beschaltungen schützen diese abschaltbaren Leistungshalbleiter gegen Überspannungen bzw. Überbeanspruchung beim Ein- und Abschalten.

Bei Schaltvorgängen verursachen Induktivitäten im Leistungsteil von Stromrichtern meist energiereiche Überspannungen, die je nach Höhe und Dauer zur Beschädigung elektrischer Bauteile führen können. Vor allem die relativ schnell schaltenden IGBT-Module selbst sind dabei gefährdet. Zum Schutz gegen solche Überspannungen ist es vorteilhaft, zunächst die parasitären Induktivitäten im Hauptstromkreis durch günstige Leitungsführung zu minimieren. Sodann werden verschiedenartige Beschaltungsnetze genutzt und auf kürzeste Weise mit den zu schützenden abschaltbaren Leistungshalbleitern verbunden. Diesen kommt außerdem die Aufgabe zu, den Betrieb im erlaubten Rückwärts-Arbeitsbereich "RBSOA" zu gewährleisten, sowie mitunter auch die Abschaltverlustleistung herabzusetzen.

Eine bekannte RCD-Einzelbeschaltung besteht aus einem Kondensator, der in Reihe zu einer Diode mit parallelem Widerstand liegt. Diese RCD-Einzelbeschaltung ist jedem Transistor des Moduls zugeordnet. Beim Abschalten eines IGBT fließt der Hauptstrom zunächst durch die Diode und lädt den Kondensator auf. Dessen Spannung ist nahezu identisch mit der Kollektor-Emitter-Spannung des IGBT und nimmt zeitabhänhig solange zu, bis die zugehörige Freilaufdiode im Lastkreis leitend wird. Die demzufolge begrenzte Spannungssteilheit mindert die bei Abschalten im IGBT auftretende Verlustleistung, was mit zunehmender Impulsfrequenz bedeutend werden kann. Die im Kondensator gespeicherte Energie wird beim nächsten Einschalten über den Beschaltungswiderstand abgebaut. Dies ist aber grundsätzlich unerwünscht, weil z.B. bei höherer Pulsfrequenz die am Beschaltungswiderstand in Wärme umgesetzte Verlustleistung beachtliche Werte annimmt. Deshalb werden mitunter aufwendige Beschaltungsnetze verwendet, die ein nutzbringendes Rückführen der Energie aus dem Kondensator ermöglichen.

Eine kostengünstigere Maßnahme ist der RCD-Spannungsbegrenzer für Zweigpaare bzw. Module oder die Summenbeschaltung auf der Gleichstromseite, die außerdem weniger Verlustleistung verursachen. Dafür sind diese allerdings auch nicht so wirkungsvoll.

Als RCD-Spannungsbegrenzer für Zweigpaare kann die aus der Zeitschrift "etz", Band 110, 1989, Heft 10, Seiten 464 bis 471, bekannte RCD-Zweigpaarbeschaltung, auch als sogenannte RCD-Kreuzbeschaltung bekannt, verwendet werden. Diese RCD-Zweigpaarbeschaltung ist besonders bei Stromrichtern mit höheren Ausgangsströmen zu bevorzugen, weil sie die kürzeren Leitungslängen im Beschaltungsnetz ermöglicht. Die beim Abschalten der IGBT aus der parasitären Induktivität resultierende Energie gelangt über die jeweils betroffene Diode zu dem entsprechend zugeordneten Kondensator. Nur dieser Energieanteil - und nicht die gesamte in den Kondensatoren gespeicherte Energie - muß bis zum nächsten Abschaltvorgang an den beteiligten Widerständen abgebaut werden. Ein zu weit gehendes Entladen des Kondensators wird dabei schaltungsbedingt vermieden. Die aus dieser Beschaltungsmethode resultierende Verlustleistung ist deshalb verhältnismäßig gering. Dafür wird hier - im Gegensatz zur RCD-Einzelbeschaltung - die Spannungssteilheit beim Abschalten und folglich auch die Abschaltverlustleistung nicht gemindert, so daß sich die IGBT mit zunehmender Impulsfrequenz etwas stärker erwärmen.

Bei Wechselrichtern in Zweipuls- oder Sechspuls-Brückenschaltungen kann für die relativ schnell schaltenden IGBT-Module eventuell auch die besonders kostengünstige Summenbeschaltung auf der Gleichstromseite verwendet werden. Der Funktionsablauf sowie die Auswirkung dieser Beschaltungsmaßnahmen sind der von RCD-Spannungsbegrenzern für Zweigpaare ähnlich.

Im Bedarfsfall ergänzend eingefügte Dämpfungskondensatoren relativ kleiner Kapazität reduzieren den Einfluß der verbleibenden parasitären Induktivitäten in den jeweiligen Zweig-Verbindungsleitungen. Ihr Anteil an der Beschaltungsverlustleistung ist unbedeutend.

Aus dem deutschen Gebrauchsmuster 90 12 147 ist ein Beschaltungsnetz für eine Schaltungsanordnung mit zwei schnellschaltenden bipolaren Transistoren bekannt, das aus einer RCD-Beschaltung besteht. Außerdem ist dieses Zweigpaar mit einer RC²-Beschaltung, bestehend aus zwei Kondensatoren und einem Widerstand, die eine T-Schaltung bilden, vorgesehen, deren Anschlüsse mit den Anschlüssen der Schaltungsanordnung derart elektrisch leitend verbunden sind, daß jeweils ein Kondensatoranschluß mit einem Eingangsanschluß und der Widerstandsanschluß mit einem Wechselstromausgang der Schaltungsanordnung verknüpft sind. Durch die Ergänzung der RCD-Beschaltung (RCD-Kreuzbeschaltung bzw. RCD-Summenbeschaltung) durch die benannte RC²-Beschaltung erhält man ein Beschaltungsnetz für eine Schaltungsanordnung mit schnellschaltenden bipolaren Transistoren mit dem die hochfrequenten Spannungsschwingungen und die schmalen Spannungssspitzen gedämpft und geglättet werden. Dabei glätten die in Reihe geschalteten Kondensatoren die Spannungsspitzen zwischen den Plus-Minus-Anschlüssen der Schaltungsanordnung. Der Widerstand dämpft die Schwingung mit einem Zwischenkreis-Kondensator. Gleichermaßen werden die Schwingungen des Modul-Ausgangs gedämpft.

Bei der Verwendung der bekannten RCD-Zweigpaarbeschaltung, auch RCD-Kreuzbeschaltung genannt, bei mehrpulsigen Stromrichter-Brückenschaltungen größerer Leistung sind folgende Probleme festgestellt worden:
Bei Kommutierungsvorgängen kommt es infolge von auftretenden Überspannungen am kommutierenden Stromrichterventil zu Spannungsüberhöhungen auf der Zwischenkreisverschienung des die mehrpulsige Stromrichter-Brückenschaltung enthaltenden Umrichters. Diese Spannungsüberhöhung ist umso größer, je mehr Zweige der mehrpulsigen Stromrichter-Brückenschaltung bzw. des Umrichters gleichzeitig größe Ströme kommutieren. Als Folge dieser Spannungsüberhöhung auf der Zwischenkreisverschienung fließen in den nicht kommutierenden Zweigen große Ströme über die Kondensatoren und Dioden der RCD-Zweigpaarbeschaltung. Diese den Ausgangsströmen überlagerten Ströme können bei Verwendung von einer U_{CE}-Überwachungsschaltung eine Fehlermeldung auslösen bzw. eine Abschaltung des Umrichters bewirken, obwohl kein Fehlerfall (Überstrom/Überbelastung bzw. Kurzschluß) aufgetreten ist.

Ein weiteres Problem tritt auf, wenn während einer Leitphase einer Beschaltungsdiode der RCD-Beschaltung auch der Strom auf das zugehörige Stromrichterventil kommutiert. Dadurch wird der Beschaltungskondensator der zugehörigen RCD-Beschaltung über das einschaltende Stromrichterventil und die leitende Beschaltungsdiode kurzgeschlossen. Diese Beschaltungsdiode muß in diesem Betriebszustand einen sehr großen Rückstrom tragen und gegen die Zwischenkreisspannung abschalten können. Dies stellt eine enorme und eventuell zu große Belastung dar, die nicht ohne weiteres durch die Verwendung einer leistungsstärkeren Beschaltungsdiode in den Griff zu bekommen ist.

Der Erfindung liegt nun die Aufgabe zugrunde, diese auftretenden Probleme bei der Verwendung von RCD-Zweigpaarbeschaltungen bei mehrpulsigen Stromrichter-Brückenschaltungen auf einfache und kostengünstige Art und Weise zu lösen.

Diese Aufgabe wird erfindungsgemäß mit dem kennzeichnenden Merkmal des Anspruchs 1 gelöst.

Durch die Ergänzung jeweils der RCD-Beschaltung der RCD-Zweigpaarbeschaltung durch eine weitere Diode erhält man ein Beschaltungsnetz für Zweigpaare, auch als RCD²-Zweigpaarbeschaltung bezeichnet, mit dem die Spannungsüberhöhung auf der Zwischenkreisverschienung bei Kommutierungsvorgängen sich verringern, da mittels dieser weiteren Dioden jeder Beschaltungskondensator der Beschaltungsnetze der Zweigpaare bei jeder Kommutierung mitwirkt. D.h, die Spannung der Zwischenkreisverschienung wird jeweils durch zwei Beschaltungskondensatoren der RCD-Beschaltungen pro Zweigpaar gestützt bzw. auf die Zwischenkreisspannung geklemmt.

Infolge einer geringeren Spannungsüberhöhung auf der Zwischenkreisverschienung fließt auch ein geringerer Strom durch einen Beschaltungskondensator und eine Beschaltungsdiode einer RCD-Beschaltung eines nicht an der Kommutierung beteiligten Stromrichterventils. Durch die weitere Diode pro RCD-Beschaltung wird dieser Strom im wesentlichen von der Beschaltungsdiode ferngehalten, so daß, wenn der Laststrom während der Leitphase dieser Beschaltungsdiode auf das zugehörige Stromrichterventil kommutiert, diese Beschaltungsdiode nicht mehr übermäßig belastet wird. Dadurch erhöht sich die Zuverlässigkeit eines Stromrichters ohne dabei einzelne Bauelemente überdimensionieren zu müssen. Ebenso werden die Fehlmeldungen der verwendeten U_{CE}-Überwachungsschaltungen verhindert, so daß diese Überwachungsschaltungen aufgabengemäß arbeiten können.

Somit erhält man durch die Ergänzung jeweils der RCD-Beschaltungen einer RCD-Zweigpaarbeschaltung durch eine weitere Diode auf einfache und kostengünstige Art und Weise ein Beschaltungsnetz für ein Zweigpaar, auch RCD²-Zweigpaarbeschaltung genannt, bei dem die eingangs angesprochenen Probleme nicht mehr auftreten.

Außerdem kann man durch diese erfindungsgemäße Ergänzung bestehende Beschaltungsnetze von Zweigpaaren ohne größeren Aufwand zu erfindungsgemäßen RCD²-Zweigpaarbeschaltungen aufrüsten. Dabei ist es vorteilhaft, wenn diese weiteren Dioden jeweils niederinduktiv über die zugehörigen Beschaltungskondensatoren elektrisch leitend mit den Gleichspannungs-Anschlüssen der Zweigpaare verbunden werden. D.h., der Strompfad über die weitere Diode muß niederinduktiver sein als der Strompfad über einem Beschaltungskondensator und einem Leistungshalbleiter eines Zweigpaares.

Zur weiteren Erläuterung der Erfindung wird auf die Zeichnung Bezug genommen, in der ein Beschaltungsnetz für ein Zweigpaar eines Stromrichters schematisch veranschaulicht ist.
- Figur 1: zeigt das Ersatzschaltbild eines Traktionsantriebs für eine Nahverkehrsbahn, in
- Figur 2: ist eine bekannte RCD-Zweigpaarbeschaltung bei einer sechspulsigen Stromrichter-Brückenschaltung dargestellt und die
- Figur 3: veranschaulicht eine erfindungsgemäße RCD²-Zweigpaarbeschaltung für ein Zweigpaar bei einer sechspulsigen Stromrichter-Brückenschaltung.

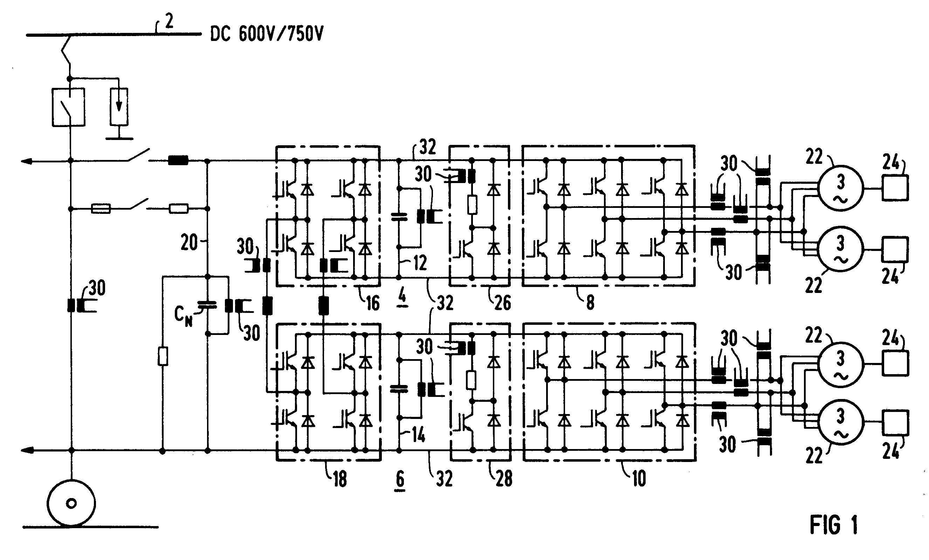

Die Figur 1 zeigt ein Ersatzschaltbild eines Traktionsantriebs einer Nahverkehrsbahn, die an einem 600 V bzw. 750 V Gleichspannungs-Fahrdraht 2 betrieben wird. Die Starkstromausrüstung dieses Traktionsantriebs enthält zwei Transistor-Stromrichter 4 und 6 mit beispielsweise IGBT-Transistoren. Der Transistor-Stromrichter 4 bzw. 6 enthält einen Wechselrichter 8 bzw. 10, einen Zwischenkreis 12 bzw. 14 und einen Eingangsstromrichter 16 bzw. 18. Beide Transistor-Stromrichter 4 und 6 sind mit einem gemeinsamen Netzfilter 20 verbunden. Als Eingangsstromrichter 16 bzw. 18 ist ein Hoch-/Tiefsetzsteller vorgesehen, dessen Aufbau und Funktionsweise in der EP 0 384 222 A1 ausführlich beschrieben ist. Jeder Wechselrichter 8 und 10 speist zwei Drehstrommotoren 22, die jeweils mit einem Tacho 24 verknüpft sind. Zum Bremsen ist jeder Transistor-Stromrichter 4 und 6 mit einer Bremsschaltung versehen. Diese Bremsschaltung arbeitet als gemischte Netz-/Widerstandsbremse mit Vorrang für die Funktion Netzbremse. Die Aufteilung der beim Bremsen anfallenden Energie auf Netz- und einem Bremswiderstand erfolgt durch die Bremssteller 26 und 28. Außerdem sind diese Transistor-Stromrichter 4 und 6 und der Netzfilter 20 mit Wandler 30 zur Erfassung von Meßgrößen versehen.

Beim Betrieb der Nahverkehrsbahn werden mehrere Transistoren des Wechselrichters 8 bzw. 10 und des Eingangsstellers 16 bzw. 18 gleichzeitig angesteuert. D.h., mehrere Zweige kommutieren gleichzeitig größere Ströme, wodurch es zu Spannungsüberhöhung auf der Zwischenkreisverschienung 32 kommt. Wie eingangs bereits angesprochen, ist die Höhe dieser Spannungsüberhöhung von der Anzahl der gleichzeitig kommutierenden Zweige abhängig.

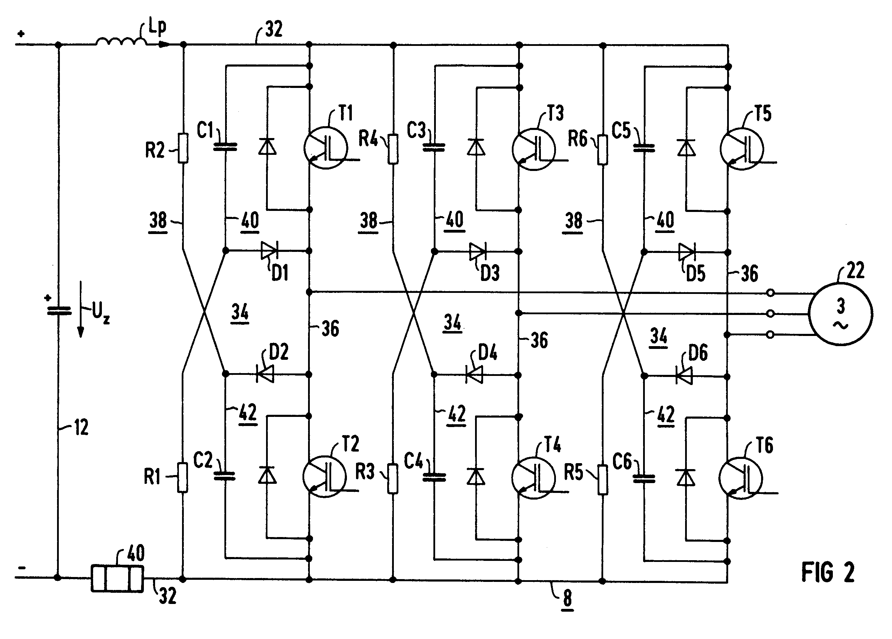

Die Figur 2 zeigt einen Ausschnitt des einen Transistor-Stromrichters 4 des Traktionsantriebs einer Nahverkehrsbahn nach Figur 1. Dieser Ausschnitt umfaßt den Zwischenkreis 12, einen Teil der Zwischenkreisverschienung 32, den Wechselrichter 8 und einen Drehstrommotor 22. Dieser Wechselrichter 8 ist aus drei Phasenbausteinen 34 aufgebaut. Jeder Phasenbaustein 34 besteht aus einem Zweigpaar 36, dem eine RCD-Zweigpaarbeschaltung 38, auch RCD-Kreuzbeschaltung genannt, zugeordnet ist. Diese bekannte RCD-Zweigpaarbeschaltung 38 besteht aus zwei RCD-Beschaltungen 40 und 42, wobei jeweils die Reihenschaltung, bestehend aus dem Beschaltungskondensator C1 bzw. C2 und der Beschaltungsdiode D1 bzw. D2, elektrisch parallel zum zugehörigen abschaltbaren Leistungshalbleiter T1 bzw. T2 geschaltet ist und der zugehörige Beschaltungswiderstand R1 bzw. R2 den Verbindungspunkt des Kondensators C1 bzw. C2 mit der Diode D1 bzw. D2 mit der negativen bzw. positiven Zwischenkreisschiene der Zwischenkreisverschienung 32 elektrisch leitend verbindet.

Das Zweigpaar 36 besteht aus zwei elektrisch in Reihe geschalteten abschaltbaren Leistungshalbleitern T1,T2 bzw. T3,T4 bzw. T5,T6. Als abschaltbarer Leistungshalbleiter T1 bzw....bzw.T6 ist beispielsweise ein Insulated-Gate-Bipolar-Transistor (IGBT) vorgesehen. Außerdem kann als abschaltbarer Leistungshalbleiter T1 bzw....bzw.T6, auch Stromrichterventil genannt, auch ein bipolarer Leistungstransistor (LTR) vorgesehen sein.

Die parasitären Induktivitäten in diesem Ausschnitt des Transistor-Stromrichters 4 ist durch eine Induktivität Lp zusammengefaßt, die beispielsweise ersatzschaltbildweise in der positiven Zwischenkreisschiene zusammengefaßt ist. In der negativen Zwischenkreisschiene ist zum Schutz des Wechselrichters 8 eine Sicherung 44 eingefügt, wodurch sich der Wert der parasitären Induktivität Lp dieses Aufbaus erhöht.

Die Überspannung, vor denen die abschaltbaren Leistungshalbleiter T1,T2 bzw. T3,T4 bzw. T5,T6 der Zweigpaare 36 geschützt werden sollen, entsteht während der Lastkommutierung eines Brückenzweiges. Diese Überspannung wird mittels der bekannten RCD-Beschaltung begrenzt. Durch die Beschaltungswiderstände R1 bis R6 sind die Beschaltungskondensatoren C1 bis C6 der Beschaltungsnetze 38 der Phasenbausteine 34 des Wechselrichters 8 auf den Wert der Zwischenkreisspannung U_{Z} des Zwischenkreises 12 geladen. Die beim Abschalten der abschaltbaren Leistungshalbleiter T1 bis T6 aus der parasitären Induktivität Lp resultierende Energie gelangt über die jeweils betroffene Diode D1,D3,D5 oder D2, D4,D6 zu den entsprechenden Kondensatoren C1,C3,C5 oder C2, C4,C6. Dadurch erhöht sich jeweils die Spannung an den Kondensatoren C1,C3,C5 oder C2,C4,C6. Diese Spannungserhöhung macht sich als pulsende Spannungsüberhöhung auf der Zwischenkreisverschienung 32 bemerkbar. Je mehr Phasenbausteine 34 gleichzeitig größere Ströme kommutieren, je höher ist der Wert dieser Spannungsüberhöhung. Dabei kann der Wert der Spannungsüberhöhung bis zu einem Viertel der Zwischenkreisspannung U_{Z} ansteigen. Dadurch stellt sich ein Strom ein, der sich dem Laststrom überlagert. Die Höhe des infolge der Spannungsüberhöhung fließenden Stromes kann bis zu 50 % des Laststromes betragen, wodurch hier nicht näher dargestellte U_{CE}-Überwachungsschaltungen zu Fehlmeldungen neigen.

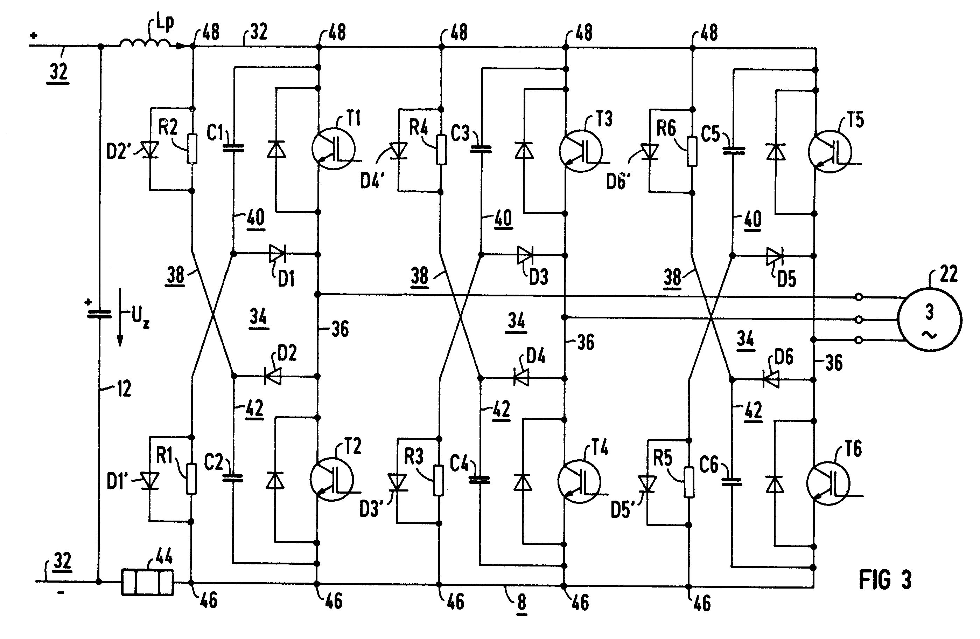

Bei der erfindungsgemäßen RCD²-Zweigpaarbeschaltung für ein Zweigpaar 36 gemäß Figur 3 ist jeweils zum Beschaltungswiderstand R1 bzw. R2 der RCD-Beschaltung 40 und 42 der bekannten RCD-Zweigpaarbeschaltung 38 eine weitere Diode D1' bzw. D2' elektrisch parallel geschaltet. Dabei ist die erste weitere Diode D1' derart elektrisch parallel zum Beschaltungswiderstand R1 geschaltet, daß deren Anode mit dem Verbindungspunkt des Beschaltungskondensators C1 mit der Beschaltungsdiode D1 und deren Kathode mit dem negativen Gleichspannungs-Anschluß 46 des Zweigpaares 36 bzw. des Phasenbausteins 34 elektrisch leitend verknüpft ist. Die zweite weitere Diode D2' ist derart elektrisch leitend parallel zum Beschaltungswiderstand R2 geschaltet, daß deren Anode mit dem positiven Gleichspannungs-Anschluß 48 des Zweigpaares 36 bzw. des Phasenbausteins 34 und deren Kathode mit dem Verbindungspunkt des Beschaltungskondensators C2 mit der Beschaltungsdiode D2 elektrisch leitend verbunden ist. Um den Wert der parasitären Induktivität Lp nicht wesentlich zu erhöhen, muß jede weitere Diode D1', ...,D6' niederinduktiv über den zugehörigen Beschaltungskondensator C1,...,C6 mit den Gleichspannungs-Anschlüssen 48und 46 der Zweigpaare 36 verbunden werden. Durch diese weiteren Dioden D1',...,D6' ist das Potential der Zwischenkreisverschienung 32 mittels der Beschaltungskondensatoren C1, ...,C6, die jeweils auf den Wert der Zwischenkreisspannung U_{Z} aufgeladen sind, auf den Wert der Zwischenkreisspannung U_{Z} geklemmt. Durch diese mehrfache (sechsfach) Klemmung des Potentials der Zwischenkreisverschienung 32 verringert sich der Wert der Spannungsüberhöhung auf der Zwischenkreisverschienung 32 erheblich. D.h., die beim Abschalten der abschaltbaren Leistungshalbleiter T1,...,T6 entstehenden Überspannungen können sich infolge der durch die mehrfache Klemmung des Potentials der Zwischenkreisverschienung 32 auf die Zwischenkreisspannung U_{Z} viel weniger bemerkbar machen, da durch diese weiteren Dioden D1',..., D6' das Potential der Zwischenkreisverschienung 32 zu einer sehr stabilen Spannung umgewandelt worden ist.

Infolge der Spannungsstabilisierung auf der Zwischenkreisverschienung 32, d.h. einer sehr viel geringeren Spannungsüberhöhung, kann sich nun auch nur ein viel geringerer Strom einstellen, der sich dem Laststrom überlagert kann. Dadurch können die nicht näher dargestellten U_{CE}-Überwachungsschaltungen wieder ihre aufgabengemäße Funktion übernehmen, wodurch die Betriebssicherheit des Wechselrichters 8 wesentlich verbessert wird. Außerdem wird der sich einstellende Strom mittels dieser weiteren Dioden D1',...,D6' zum überwiegenden Teil von der leitfähigen Beschaltungsdiode D1,...,D6 ferngehalten, so daß, wenn der Laststrom auf ein zu einer leitfähigen Beschaltungsdiode D1 bzw. ... bzw. D6 zugehörigem Stromrichterventil T1 bzw. ... bzw. T6 kommutiert, diese Beschaltungsdiode D1,...,D6 nicht mehr übermäßig belastet wird.

Somit erhält man auf einfache und kostengünstige Art und Weise aus einer bekannten RCD-Zweigpaarberschaltung 38 für Zweigpaar 36 eines Wechselrichters 8 größerer Leistung das erfindungsgemäße Beschaltungsnetz für Zweigpaare 36, auch RCD²-Zweigpaarbeschaltung genannt, ohne daß die eingangs angesprochenen Probleme noch auftreten.

## Patentansprüche

1. Beschaltungsnetz für ein aus zwei abschaltbaren Leistungshalbleitern (T1,T2;T3,T4;T5,T6) bestehendes Zweigpaar (36), bestehend aus einer RCD-Zweigpaarbeschaltung (38), die zwei RCD-Beschaltungen (40,42)enthält, **dadurch gekennzeichnet,** daß jeweils zu einem Widerstand (R1,R2;R3,R4;R5,R6) der RCD-Beschaltungen (40,42) derart eine weitere Diode (D1',D2';
D3',D4';D5',D6') elektrisch parallel geschaltet ist, daß die Anode der einen weiteren Diode (D2',D4',D6') elektrisch leitend mit einem positiven Gleichspannungs-Anschluß (48) und die Kathode der anderen weiteren Diode (D1',D3',D5') elektrisch leitend mit einem negativen Gleichspannungs-Anschluß (46) des Zweigpaares (36) verknüpft sind.

2. Beschaltungsnetz nach Anspruch 1, **dadurch gekennzeichnet,** daß jeweils die weitere Diode (D1',D2';D3',D4';D5',D6') niederinduktiv über den zugehörigen Beschaltungskondensator (C1,C2;C3,C4;C5,C6) der RCD-Beschaltung (40,42) mit den Gleichspannungs-Anschlüssen (48,46) des Zweigpaares (36) verknüpft ist.

3. Verwendung von zwei Zweigpaaren (36), die jeweils mit einem Beschaltungsnetz nach Anspruch 1 versehen sind, als zweipulsige Stromrichter-Brückenschaltung.

4. Verwendung von drei Zweigpaaren (36), die jeweils mit einem Beschaltungsnetz nach Anspruch 1 versehen sind, als sechspulsige Stromrichter-Brückenschaltung.
